# EUROPEAN PATENT APPLICATION

(11) **EP 4 280 288 A1**
(43) Date of publication of application: **22.11.2023**
(21) Application number: 22181060.9
(22) Date of filing: 24.06.2022
(51) Int. Cl.: H01L 31/049, H01L 31/048, H02S 40/40

(54) **PHOTOVOLTAIC SANDWICH PANEL, PARTICULARLY PV VEHICLE CLADDING SANDWICH PANEL, AND THERMALLY INSULATED CARGO BOX AS WELL AS VEHICLE COMPRISING SUCH PANEL AND MANUFACTURING METHOD**

(30) Priority: 20.05.2022 DE 202022102822 U
(71) Applicant: Sono Motors GmbH, 80935 München (DE)
(72) Inventor: GIRI, Priyanka, 80935 Munich (DE); CALCABRINI, Andres, 80935 Munich (DE); BAUDRIT, Mathieu, 80935 Munich (DE); ARROMBA, Iara, 80935 Munich (DE)
(74) Representative: Qip Patentanwälte Dr. Kuehn & Partner mbB

(57) **Abstract**

A photovoltaic sandwich panel (1), particularly photovoltaic vehicle cladding sandwich panel, is proposed to comprise a sheet-like photovoltaic label (3), a foam sheet (5) and a stabilisation layer (7). The photovoltaic label (3) comprises a front side stabilisation foil (9), a front side polymeric lamination foil (11), a rear side polymeric lamination foil (13) and a solar cell arrangement (17) interposed between the front and rear side lamination foils (11, 13). The stabilisation layer is (7) fixed to a rear side (23) of the foam sheet (5) and the photovoltaic label (3) is fixed with its rear side to a front side (21) of the foam sheet (5). The sandwich panel (1) may be used for a thermally insulated cargo box of e.g. a vehicle such as a refrigerated truck or trailer.

## Description

### FIELD OF THE INVENTION

The present invention relates to a sandwich panel, particularly to a vehicle cladding sandwich panel, and to a thermally insulated cargo box comprising such panel as well as a vehicle comprising such panel and to a method for manufacturing such sandwich panel.

### TECHNICAL BACKGROUND

In the following, the term "photovoltaic" may be abbreviated by "PV". PV cells may also be referred to as solar cells.

Furthermore, while the term "vehicle cladding sandwich panel" may refer to a panel which may be included in and/or attached to a body of any kind of vehicles such as cars, trucks, trailers, busses, mobile homes, trains, ships, airplanes, etc., embodiments are described herein with reference to panels forming a cargo box of a truck or a trailer, for simplicity of description.

Conventionally, thermally sensitive goods such as certain food may be stored and/or transported in thermally insulated cargo boxes. Such cargo boxes may be carried on or integrated into vehicles such as refrigerated trucks or trailers, sometimes also referred to as reefers. Therein, the cargo box comprises multiple insulation panels enclosing a cargo volume. Each insulation panel typically comprises a thermally insulating foam. An interior volume of the cargo box is generally cooled or air-conditioned using a cooling unit. Accordingly, the cargo box may act as a large refrigerator.

In a conventional cargo box, the foam of an insulation panel is typically interposed between a front side stabilisation layer and a rear side stabilisation layer. The foam may be optimised with regards to its thermally insulation characteristics and may provide the panel with a low heat transmission coefficient. However, the foam is typically soft, instable and/or not self-supporting. The stabilisation layers are typically substantially more rigid and mechanically loadable than the interposed foam. Accordingly, a sandwich panel formed by the foam together with the stabilisation layers at both opposite surfaces of the foam generally has a sufficient mechanical stability such as to serve as a side wall, roof and/or bottom of the cargo box.

### SUMMARY OF THE INVENTION AND OF EMBODIMENTS

There may be a need for a sandwich panel which may, inter-alia, be used for a thermally insulated cargo box and a vehicle provided therewith, wherein the sandwich panel is configured for providing additional functionalities. Particularly, there may be a need for a sandwich panel including integrated photovoltaics for electricity generation. More particularly, there may be a need for a photovoltaic sandwich panel which may have a space saving construction, particularly a limited thickness, which may have a low weight, which may be robust, which may be simple to fabricate and/or which may be inexpensive. Furthermore, there may be a need for a thermally insulated cargo box comprising such PV sandwich panel and to a vehicle carrying such cargo box. Finally, there may be a need for a method for manufacturing such PV sandwich panel.

Such need may be met with the subject matter of the independent claims. Advantageous embodiments and characteristics are defined in the dependent claims and are described in the present specification and visualised in the accompanying figures.

The applicant of the present application has proposed in various earlier patent applications to include photovoltaic cells into body parts or cladding parts of a vehicle, particularly of an electric vehicle. Such approaches are also referred to as the vehicle integrated photovoltaics (VIPV) or solar electric vehicles (SEV). Examples of such applications are WO 2019/020718 A1, WO 2020/187792 A1, GB 2019566.5, WO 2021/260024 A1, WO 2021/260021 A1 and EP 22 168 975.5. Possible features and characteristics of such approaches of car body panels and approaches for fabricating a car body panel including a photovoltaic module may also apply to the photovoltaic sandwich panel described herein and the content of the earlier patent applications shall be incorporated in its entirety herein by reference.

According to a first aspect of the present invention, a photovoltaic sandwich panel, particularly photovoltaic vehicle cladding sandwich panel, is described. The PV sandwich panel comprises at least the following components: a sheet-like photovoltaic label, a foam sheet and a stabilisation layer. Therein, the photovoltaic label comprises a a front side polymeric lamination foil, a rear side polymeric lamination foil and a solar cell arrangement interposed between the front and rear side lamination foils. The stabilisation layer is fixed to a rear side of the foam sheet. The photovoltaic label is fixed with its rear side to a front side of the foam sheet.

According to a second aspect of the invention, a thermally insulated cargo box is described. The cargo box comprises a cargo volume enclosed by multiple insulation panels including a roof panel, a bottom panel and several side panels. Therein, at least one of the insulation panels is made with a photovoltaic sandwich panel according to an embodiment of the first aspect of the invention.

According to a third aspect of the invention, a vehicle comprising a thermally insulated cargo box according to an embodiment of the second aspect of the invention is described.

Briefly summarised and without limiting the scope of the invention, basic ideas underlying embodiments of the invention and associated possible advantages will be roughly described as follows:
As indicated above, conventional sandwich panels for use in a thermally insulated cargo box generally comprise front and rear side stabilisation layers enclosing an interposed foam sheet, wherein the foam sheet provides for the required thermal insulation and the stabilisation layers provide for a mechanical stability and loadability of the panel. It may be seen as a basic idea underlying the approach described herein to add a photovoltaics functionality to such sandwich panel. Particularly, one of the stabilisation layers of such conventional sandwich panel may be replaced by or added by a specific sheet-like PV label. Such PV label comprises a solar cell arrangement with multiple solar cells interposed between front and rear side lamination foils and is further stabilised by at least one additional stabilisation foil covering a front side of the PV label. As the PV label may be very thin for example compared to conventional PV modules, the entire stack comprising the foam sheet, the stabilisation layer and the PV label may have similar dimensions, particularly a similar thickness, and/or a similar weight as conventional non-PV sandwich panels. However, while such PV sandwich panel may be manufactured using similar techniques as used for conventional sandwich panel manufacturing and may have similar physical characteristics, particularly similar thermal and mechanical characteristics, as conventional sandwich panels, the PV sandwich panel proposed herein may provide an additional functionality of producing electricity upon being irradiated with sunlight. Such electric energy may be used for example for operating a refrigerating unit for cooling the cargo box, for charging batteries of an electric vehicle and/or the electric energy may be supplied to the grid or an external consumer.

In the following, possible features of embodiments of the invention and associated possible advantages will be described in more detail.

Upon designing and manufacturing a thermally insulated cargo box for example for a refrigerated truck or a refrigerated trailer, trade-offs have to be taken into account. For example, on the one hand, an inner volume of the cargo box should be maximised. For practical reasons, a width of the cargo box should generally be at least 2.4 m such as to enable accommodating Euro-pallets in a space saving manner, such pallets typically having dimensions of 1.2 x 0.8 m². On the other hand, outside dimensions of such cargo box are typically limited by regulations and laws. Example, regulations may rule that a width of a cargo box on a truck or trailer is not allowed to be more than 2.6 m, 2.55 m, 2.5 m or even smaller, depending on national regulations and/or a type of the vehicle. Accordingly, the panels forming the outer walls of such cargo box should generally not exceed a predefined thickness. However, in order to maximise thermal insulation, a portion of the panel filled with foam should be as large as possible. Accordingly, any stabilisation layer or other outer cover layer should be as thin as possible.

In order to provide a cargo box with an electricity generating functionality, it would be imaginable to cover an outer surface of the cargo box with conventional PV panels. Such conventional PV panels typically comprise solar cells encapsulated between lamination foils and covered at its front side with a glass sheet and supported at its rear side with a backsheet, the entire stack then be held in a frame. However, due to such construction, conventional PV panels are generally relatively thick and heavy. Furthermore, having a glass sheet at its front side, such conventional PV panels are generally relatively fragile and may be damaged for example upon mechanical stress being applied. It has therefore been found that providing a cargo box with conventional PV panels may not satisfy the requirements posed to a cargo box for vehicle applications.

As an alternative, it is suggested herein to use a specific sheet-like photovoltaic label for covering an outside surface of a sandwich panel. Therein, the PV label may replace a conventional front side stabilisation layer or may be added to such front side stabilisation layer. The PV label does not comprise a glass cover sheet. Instead, the solar cell arrangement is encapsulated between front and rear side polymeric lamination foils. As a preferable option, the PV label further comprises an additional front side stabilisation foil which is provided for mechanically stabilising the PV label. As a further option, the PV label may further comprise a rear side stabilisation foil. The front and rear side stabilisation foils may enclose the front and rear side lamination foils such as to form an outermost layer, respectively. Generally, the front and/or rear side stabilization foils may have a higher thickness, a higher rigidity, a higher scratch resistance and/or a higher impact resistance than the lamination foils. Furthermore, while the stack including the front and rear side polymeric lamination foils and the solar cell arrangement may or may not be self-supportive, the stack additionally including the at least one stabilization foil typically is self-supportive. Such front and/or rear side stabilisation foils may be made of a polymer material. Optionally, such stabilisation foil may be fibre-reinforced.

Overall, the PV label typically has a significantly smaller thickness and lower weight as compared to conventional PV panels. Furthermore, the solar cell arrangement in the PV label may be well protected by the encapsulation formed by the lamination foils and, as a preferred optional addition, by the front side stabilisation foil, on the one side, and may be mechanically supported and for example protected against excessive bending by the foam sheet and the rear side stabilisation layer.

Due to the small thickness of the PV label, even though there may be dimension restrictions with regards to a thickness of the entire PV sandwich panel, the foam sheet may have a significant thickness. For example, such thickness may amount to more than 80%, preferably more than 90% and more preferably more than 95% of the entire thickness of the PV sandwich panel. For example, the foam sheet may have a thickness of between 0.5 cm and 15 cm, preferably between 0.5 cm and 12 cm, between 0.5 cm and 10 cm or between 1 cm and 8 cm, more preferably between 2 cm and 6 cm.

Due to, inter-alia, such significant thickness of the foam sheet, the foam sheet may be configured for having a heat transmission coefficient of less than 1 W/m², less than 0.5 W/m²K, preferably less than 0,4 W/m²K or even less than 0.3 W/m²K, such that the entire sandwich panel may have a substantial thermal insulation capacity. The foam may be open porous or closed porous. For example, foam may have a porosity, i.e. a ratio of pore volume to entire volume of the foam, of more than 80 %, preferably more than 90% or even more than 95 %, but generally less than 99 % or less than 97 %. For example, the foam may be made with or may consist of materials such as Polyurethane (PU), extruded polystyrene (XPS), expanded polystyrene (EPS). Generally, although having the additional functionality of electricity generation, the PV sandwich panel proposed herein may have a same or similar thermal insulation capacity as conventional sandwich panels in thermally insulated cargo boxes.

The approach proposed herein is particularly suitable for a PV-integrated (vehicle cladding) panel comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 27%) and a high reliability. Furthermore, well established industrial processes exist for their fabrication. Such PV cells typically have lateral dimensions of between 50x50 mm² and 300x300 mm², mostly between 150x150 mm² and 220x220 mm², with a square shape, a rectangular shape, a round shape, a semi-round shape or any other shape. Furthermore, such PV cells generally have a thickness of more than 50 µm, typically between 100 µm and 300 µm.

Each PV cell comprises electric contacts. The electric contacts of neighbouring PV cells may be interconnected via electrical connections such that these PV cells may be electrically connected in series, in parallel or in any combination of series and parallel connections. The electrical connections may be provided by one or more electrically conducting ribbons, one or more copper solderings, a conductive backsheet and/or a conductive adhesive tape between two adjacent photovoltaic cells. A plurality of interconnected PV cells forms part of a solar cell arrangement, sometimes also referred to as solar cell string. The solar cell arrangement may further comprise additional components such as external contacts via which the solar cell arrangement may be connected to an external electric circuit, such external contacts sometimes being referred to as forming part of a junction box. Furthermore, the solar cell arrangement may comprise for example bypass diodes or other electric components. Additionally, one or more release loops for releasing mechanical tensions may be included in the solar cell arrangement.

The solar cell arrangement is generally comprised in an encapsulation into which the solar cells, the electrical interconnections and possibly other components are embedded. Typically, the encapsulation comprises or consists of a thermoplastic polymer such as EVA (Ethylene Vinyl Acetate), POE (Polyolefin Elastomer) or a glass fiber reinforced polymeric material. The encapsulation may be composed of a front side polymeric lamination foil and a rear side polymeric lamination foil enclosing the plurality of solar cells from opposite sides. The lamination foils may also be referred to as encapsulation foils. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

As the solar cell arrangement in its encapsulation is generally very fragile, the solar cell arrangement including the solar cells, the electric connections and the encapsulation is reinforced by one or more stabilisation foils for forming a PV label. Preferably, a front side stabilisation foil and a rear side stabilisation foil may enclose the interposed solar cell arrangement and may form a substrate and a superstrate, respectively, prior to reinforcing the PV label by fixing it to the supporting foam sheet. In specific embodiments, the PV label may not necessarily comprise the rear side stabilisation foil. The one or more stabilisation foils may have a thickness of typically between 250µm and 2500µm. Each of the foils may adjoin and/or cover a part or an entirety of one of opposing surfaces of all of the PV cells. The polymeric stabilisation foils may be made with various polymeric materials such as, polycarbonate (PC), polyethylenterephthalat (PET), polyamide (PA), polyetheretherketone (PEEK), Acrylonitrile butadiene styrene (ABS), Polymethyl methacrylate) (PMMA), Polyvinylchlorid (PVC) or a mix of them. The polymeric material may be reinforced by long and/or short fibres such as glass fibres, carbon fibres, aramid fibres, etc. At least the front side stabilisation foil as well as the front side lamination foil shall consist of an optically translucent or transparent material. Particularly, a material forming the stabilisation foil may be a thermoplastic material, i.e. a material which becomes plastic or viscous upon being heated to elevated temperatures. The front and rear side stabilisation foils may enclose the interposed solar cell arrangement and, upon being joined with each other, encapsulate the solar cell arrangement. Optionally, glass fiber reinforced or carbon fiber reinforced plastics may be included between the polymeric foils.

Particularly, the front side stabilisation foil, the rear side stabilisation foil and the PV cells may be joined together by an application of heat and/or a lamination process. In other words, after having arranged e.g. the rear side stabilisation foil, the solar cell arrangement with its encapsulation and finally the front side stabilisation foil on top of each other in a lose manner, these stacked layers may be interconnected by mechanically joining them with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement.

Thus, the front and rear side stabilisation foils and the solar cell arrangement are joined in a lamination procedure. The lamination procedure may be integral with a lamination procedure used for forming the encapsulation embedding the PV cells, i.e. both the front and rear side stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The entire PV label may have a thickness in a range of between 0.5 mm to 10 mm, typically between 0.5 mm to 5 mm or between 1 mm and 3 mm. Lateral dimensions, i.e. a width, of the PV label may range from about 0.1 m to 5 m, typically from 0.3 m to 3 m. The PV label may be flexible and bendable and may be wound e.g. into a roll configuration in which the PV label is arranged in a cylindrical or quasi-cylindrical configuration, such that it may be e.g. stored in a space-saving manner. Therein, a bending radius may be adapted to a rigidity and/or bendability of the solar cells included in the PV label such as to reliably avoid any cell breakage. The solar cells comprised in the sandwich panel cover a substantial portion, i.e. for example more than 30%, preferably more than 50%, more than 70% or even more than 90%, of an entire area of the sandwich panel.

The PV label is generally flexible, bendable and/or, at least in some applications, not sufficiently self-supporting in order to resist for example substantive bending forces. Accordingly, for forming a more self-supporting PV panel, the PV label generally has to be reinforced by a support structure. In the PV sandwich panel proposed herein, such support structure is formed by the foam sheet and the stabilisation layer provided at the foam sheet at an opposite side with regards to the PV label. Such support structure typically has a higher mechanical rigidity and/or stability than the PV label. Such higher mechanical stability may result, inter-alia, from larger geometrical dimensions such as a larger thickness compared to the thickness of the PV label and/or higher stiffness due to material properties of the material forming the support structure, i.e. the material of the foam sheet and/or of the stabilisation layer. The support structure and the PV label are generally mechanically interconnected such that forces acting onto the PV label may be transmitted to the support structure and vice versa. Preferably, the PV label and/or the stabilisation layer is fixed to the foam sheet along its entire surface, using e.g. lamination or gluing processes. Furthermore, the rear surface of the PV label may be fixed directly to the surface of the foam sheet, i.e. without an additional foil or sheet being interposed between the foam sheet and the PV label, particularly preferable without an additional stabilization sheet such as e.g. a metal sheet (as is conventionally forming a covering outer layer in a conventional cargo box sandwich panel) being interposed.

The stabilisation layer provided at a rear side of the foam sheet may comprise the layer of fibre reinforced plastics, particularly glass fibre reinforced plastics (GRP) or carbon fibre reinforced plastics (CRP). Such fibre reinforced plastics may provide for a high mechanical rigidity and loadability of the stabilisation layer. Furthermore, such stabilisation layer may have a low weight. Alternatively, the stabilisation layer may be provided with a metal layer such as an aluminium layer, a steel layer or a steel alloy layer. Generally, the stabilisation layer may have a small thickness of for example between 0.1 mm and 5 mm, preferably between 0.2 mm and 2 mm.

According to an embodiment, the foam sheet and the photovoltaic label each comprise thicknesses which vary along lateral extensions of the respective component. The foam sheet may then be provided with depressed areas of reduced thickness such as to correspond to protruding areas of increased thickness of the photovoltaic label in a complementary configuration.

In other words, the PV label may have protruding areas of increased thickness as well as recessed areas of reduced thickness. The protruding areas may be those areas of the PV label in which solar cells are enclosed between the front and rear side lamination foils. Accordingly, the protruding areas may be referred to as active areas of the PV label. The recessed areas may be those areas of the PV label in which no solar cells are enclosed between the lamination foils and may therefore be referred to as non-active or passive areas of the PV label. Accordingly, the thickness of the PV label in the protruding areas may be larger by about the thickness of a typical solar cell, i.e. by about between 50 µm and 500 µm, than the thickness in the recessed areas. A contour of the protruding areas may substantially corresponds to a contour of a single solar cell or of a set of multiple neighbouring solar cells.

While the PV label may have areas of different thicknesses, the entire PV sandwich panel shall preferably have a smooth and planar outer surface. Accordingly, in order to suitably accommodate the PV label with its different areas of varying thicknesses, the foam sheet may be provided with depressed areas in which the protruding areas of the PV label may be partly inserted. Accordingly, a shape and/or geometry of the depressed areas in the foam sheet may correspond in a complementary manner to a shape and/or geometry of the protruding areas of the PV label.

Additionally to enabling to provide the PV sandwich panel with a planar configuration with flat outer surfaces, such adopting of the thicknesses of the foam sheet in different areas to the thicknesses of the PV label in adjacent areas may also help in avoiding excessive pressures being applied to the entire PV sandwich panel for example during a manufacturing procedure in which the foam sheet and the PV label are enclosed and pressed between planar surfaces of a mold, as described in further detail below.

According to an embodiment, the foam sheet comprises integrated electric connection structures which are configured for electrically interconnecting an electric contact provided at a surface of the photovoltaic label to a connector contact which is provided at the photovoltaic sandwich panel such as to be externally accessible.

In other words, the foam sheet may not only serve to mechanically stabilise the PV label but may also include electric connection structures in order to enable suitably electrically connecting the solar cell arrangement of the PV label to an external electric circuitry. Such electric connection structures may act and may be configured similarly to a connection box or a junction box in a conventional PV panel. Particularly, the connection structures may comprise electrical conductors such as cables, ribbons, etc. which may extend between an outer electric contact provided at the surface of the PV label, at the one side, and a connector contact, on the other side. Therein, the connector contact may be included in the PV sandwich panel such as to be accessible from an external position. For example, the connector contact may be a plug or a socket.

Accordingly, an external circuitry may be easily electrically connected to the solar cell arrangement in the PV sandwich panel. Preferably, the electric connection structures are partly or completely accommodated within the foam sheet. Accordingly, no extra construction space is required for such components.

Another aspect of the invention relates to a method for manufacturing a photovoltaic sandwich panel. The method includes at least the following steps, preferably in the indicated order:
- providing a reversible closable mold with a cavity having inner dimensions corresponding to dimensions of the photovoltaic sandwich panel;
- inserting at least a sheet-like photovoltaic label, a foam sheet and a stabilisation layer such as to form a layer stack within the cavity of the mold, wherein the photovoltaic label comprises a front side polymeric lamination foil, a rear side polymeric lamination foil and a solar cell arrangement interposed between the front and rear side lamination foils and wherein a curable layer of adhesive material is interposed between each of the components in the layer stack;
- closing the mold and, optionally, heating at least portions of the mold and/or pressing opposing surfaces of the mold such as to cure the adhesive material in the curable layers to thereby fix the stabilisation layer to the rear side of the foam sheet and to fix the photovoltaic label with its rear side to a front side of the foam sheet.

In other words, the PV sandwich panel described herein may be prepared by arranging the different layer components forming the sandwich panel in a stack arrangement and including the resulting layer stack in the inner cavity of a mold. Such mold comprises a lower wall, an upper wall and side walls enclosing the inner cavity. Typically, at least one of the lower wall and the upper wall may be displaced such as to enable reversibly opening and closing the cavity. Accordingly, the stabilisation layer, the foam sheet and the PV label may each be pre-fabricated in preceding manufacturing steps and may then be accommodated within the cavity of the mold. Furthermore, upon stacking these components, an adhesive material may be interposed between each of the components. Thus, adhesive material may be applied such as to extend between a surface of the stabilisation layer and an opposing first surface of the foam sheet at a first side of the sandwich panel and, furthermore, adhesive material may be applied such as to extend between a second surface of the foam sheet and an opposing surface of the PV label at a second side of the sandwich panel.

The adhesive material may be applied as a fluid which may then be cured such as to solidify. Such curing may be initiated or may be supported upon applying pressure and/or elevated temperatures. Alternatively, the adhesive material may be provided as a sheet, film or foil which forms a layer between surfaces of opposing components and which may adhere to such surfaces for example upon pressure and/or elevated temperatures being applied thereto. Such pressure and/or elevated temperatures may be generated using the closable and/or heatable mold.

It shall be noted that possible features and advantages of embodiments of the invention are described herein partly with respect to a PV sandwich panel, partly with respect to specific applications thereof such that in a thermally insulated cargo box and partly with respect to a method for manufacturing such PV sandwich panel. One skilled in the art will recognise that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a cross-sectional view of a photovoltaic sandwich panel in accordance with an embodiment of the present invention.
Fig. 2 shows a vehicle comprising a thermally insulated cargo box in accordance with an embodiment of the present invention.

The figures are only schematic and not to scale. Same reference signs refer to same or similar features.

### DESCRIPTION OF PREFERRED EMBODIMENTS

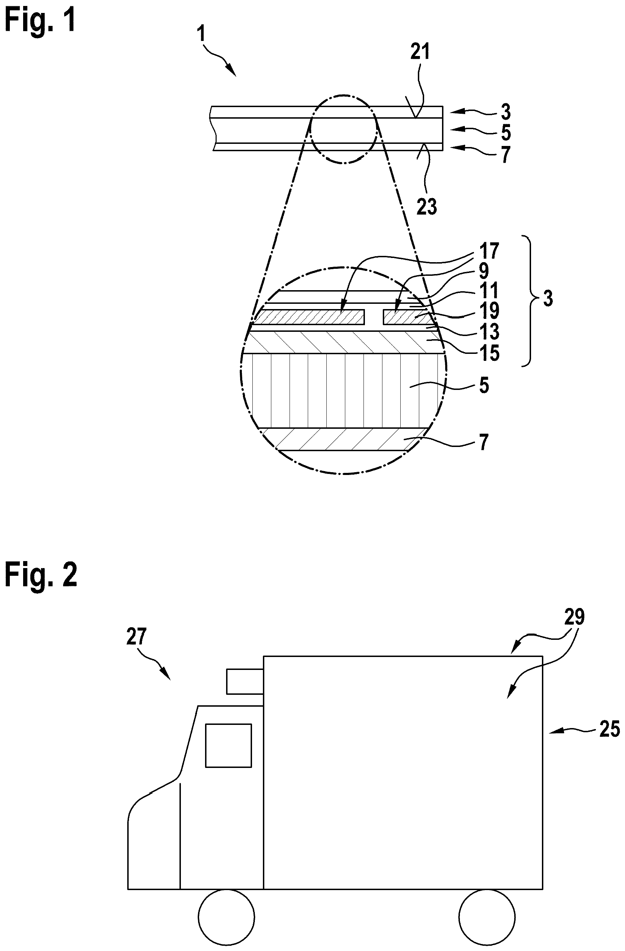

Fig. 1 shows a cross-sectional view of a PV sandwich panel 1 which may be used in a vehicle 27 such as a reefer as shown in Fig. 2. Particularly, the PV sandwich panel 1 may serve as a vehicle cladding insulation panel 29 in a cargo box 25 having both an electricity generation functionality and a thermally insulating functionality.

The PV sandwich panel 1 comprises a sheet-like PV label 3 at its front side 21, a sheet-like stabilisation layer 7 at its rear side 23 and a foam sheet 5 interposed between the PV label 3 and the stabilisation layer 7. As visualised in more detail in the enlarged portion in Fig. 1, the entire stack forming the PV sandwich panel 1 comprises the stabilisation layer 7 directly abutting to the rear side surface of the foam sheet 5 and furthermore the PV label 3 directly abutting to the front side surface of the foam sheet 5. Therein, the PV label 3 comprises a front side stabilisation foil 9, a front side polymeric lamination foil 11, a rear side polymeric lamination foil 13, a rear side stabilisation foil 15 and a solar cell arrangement 17 including multiple solar cells 19 encapsulated between the front and rear side polymeric lamination foils 11, 13.

As mentioned above, the PV sandwich panel 1 may be integrated into reefers or refrigerated semi-trailers, whereby the roof and/or sides will be equipped with solar modules by means of a vehicle applied photovoltaic process that is specifically suited for the use in cargo-box vehicles.

In the above mentioned cases, the solar power will be used to operate the cooling unit through charging the main battery. This potentially may result in up to 8.475 litres of fuel savings and reduces the local CO2 emissions by over 22 tonnes per year per vehicle for diesel powered cooling units. The solar trailers 'CO2 backpack', i.e., emissions caused in production, amounts to a one-off of approximately 6.5 metric tonnes of CO2. However, it is noted that the PV sandwich panel 1 may just as well be added to or integrated into buses, campers, motorhomes, and the like.

Next, some exemplary embodiments of PV sandwich panels for insulated cargo boxes will be described in more detail.

### Exemplary embodiment 1

A PV sandwich panel having a width of 830 cm and a length of 1600 cm has been prepared. The PV label included in the sandwich panel has a thickness of 800 µm in the active area (i.e. the area including solar cells) and a thickness of 600 µm in an inactive area (i.e. the area including no solar cells). A front side lamination foil and a rear side lamination foil both consist of polyolefin elastomer (POE). The PV label comprises a front stabilization foil and a rear stabilization foil which both consist of ethylene tetrafluoroethylene (ETFE). The PV sandwich panel comprises 30 solar cells. The solar cells have a size of 125x125 mm² and a thickness of 150 µm. Each PV sandwich panel comprises three bypass diodes.

### Exemplary embodiment 2

A PV sandwich panel having same outer dimension, same number and type of solar cells, same number of bypass diodes and same type of front and rear side lamination foils as in the first exemplary embodiment has been prepared. However, differing from the first exemplary embodiment, the PV label included in the sandwich panel has a thickness of 1000 µm in the active area and a thickness of 800 µm in the inactive area. As a further difference, the PV label comprises a front side stabilization foil and a rear side stabilization foil which both consist of polyethylene terephthalate (PET), i.e. a type of polyester.

### Exemplary embodiment 3

A PV sandwich panel having a width of 900 cm and a length of 1800 cm has been prepared. The PV label included in the sandwich panel has a thickness of 550 µm in the active area and a thickness of 350 µm in an inactive area. A front lamination foil and a rear lamination foil both consist of a glass-fibre reinforced epoxy composite. The PV label comprises no front stabilization foil and/or no rear stabilization foil. The PV sandwich panel comprises 30 solar cells each having a size of 125x125 mm² and a thickness of 150 µm. The PV sandwich panel comprises no bypass diodes.

### Exemplary embodiment 4

A PV sandwich panel having same outer dimension, same number and type of solar cells, same number of bypass diodes and same type of front and rear side lamination foils as in the third exemplary embodiment has been prepared. Again, the panel comprises no front and/or rear side stabilization foils at the PV label. However, differing from the third exemplary embodiment, the PV label included in the sandwich panel has a thickness of 800 µm in the active area and a thickness of 600 µm in the inactive area.

It is to be noted that the PV sandwich panel proposed herein may be implemented in various variations and the above exemplary embodiments shall be interpreted as forming only specific examples of such variations. Particularly, characteristics of the PV label and, more particularly, characteristics of the lamination foils, stabilisation foils and solar cells comprised therein may deviate from the characteristics mentioned in the above exemplary embodiments.

For example, the PV label generally comprises an arrangement of electrically interconnected solar cells. Preferably, the solar cells are wafer-based, i.e. are made with a rigid crystalline substrate of a semiconductor material such as silicon. The cell thickness is usually 150 µm ± 30 µm, but may generally range from 10 µm to 500 µm, preferably from 50 µm to 250 µm. The shape of the solar cells may be squared, rectangular, round or any other shape. For example, the solar cells may be half cut solar cells with a length of the solar cells being double its width. Optionally, corners of the solar cells may have a rounded contour.

Neighbouring solar cells may be electrically interconnected via one, two or preferably multiple interconnectors such as metallic ribbons. Alternatively, in a multi-busbar approach, the solar cells may have a multiplicity of busbars, i.e. for example more than 5 busbars, preferably more than 10 busbars, and each bus bar may be electrically interconnected to a busbar of an associated neighbouring solar cell via a thin wire.

In another alternative, neighbouring solar cells may be arranged such as to partly overlap each other in a shingling configuration and such neighbouring solar cells may be electrically interconnected via electrically conductive structures provided near edges of each of the solar cells, such conductive structures of the neighbouring solar cells electrically contacting each other in the overlapping areas.

The solar cells are generally encapsulated in a polymeric material which forms a foil and protects the solar cells from the environment. Particularly, the encapsulating material encloses the solar cells tightly such as to prevent moisture, humidity or any chemical substances from coming into contact with the solar cells and/or interconnectors in order to prevent, inter-alia, deteriorations such as corrosion. The polymeric material is referred to herein as lamination foil, but may also be referred to as encapsulation foil. Furthermore, such material does not necessarily have to be provided originally as a foil, but may also be formed by applying a liquids and/or vicious polymeric material for example in a form of a resin onto the solar cells, which then cures and solidifies, thereby forming a thin layer acting as a film or foil.

Additionally or alternatively to the encapsulating polymeric materials mentioned above for the exemplary embodiments, many more materials and combinations may be possible. For example, the lamination foils may be made of thermoplastic material such as ethylene vinyl acetate, polyvinyl butyral, polyolefins, etc. Alternatively, the lamination foils may be made with a combination or compound of structural fibres such as glass fibres, carbon fibres, natural fibres, etc. together with a thermosetting resin (such as polyester, epoxy, etc.) and/or a thermoplastic resin (such as polycarbonate, polyester, etc.). The thickness of the lamination foil typically ranges from 50 µm to 1500 µm.

The stabilisation foils generally provide additional resistance, rigidity and/or mechanical stability to the PV label. These foils may also be designed to improve light absorption in the PV label, for example by providing the front side stabilisation foil and/or the rear side stabilisation foil with a texture, such texture possibly improving light trapping at the "sunny-side" front side of the PV label and/or mirroring at the rear side of the PV label. When the PV label is to be integrated in a sandwich panel, the rear side stabilisation foil is not always necessary. Furthermore, for example when the solar cells are encapsulated in stable composite materials, even the front side stabilisation foil might not be necessary.

Generally, stabilisation foils are made of thermoplastic polymers (such as polyethylene terephthalate (PET), ethylene tetrafluoroethylene (ETFE), polyvinyl fluoride (PVF, etc.) forming a single layer of material.

Optionally, a protective coating and/or a laminate film may cover the stabilisation foil at at least one of its surfaces. Such protective coating or film typically combines layers of flouropolymers and/or polyesters (e.g. TPT, TPE, etc.) and/or a co-extruded film (e.g. combinations of polyester, polypropylene, polyamine, etc.).

The stabilisation foils may have a thickness ranging typically between 10 µm and 2000 µm, preferably between 25 µm and 1000 µm.

The PV sandwich panel and particularly its PV label may be provided with various dimensions. For example, the dimensions of the PV labels as stated in the above exemplary embodiments are specifically chosen for tests to be performed on CW25. These PV labels may be integrated on a sandwich panel having dimensions of 2.3 m x 1.2 m. However, it is to be noted that sandwich panels in applications such as for example reefers may generally have substantially larger dimensions. For example, on a refrigerated container of a trailer, the sandwich panels may have dimensions of up to 13.6 m by 2.4 - 2.6 m. Accordingly, the sizes of the PV labels could also be significantly larger than the dimensions indicated in the above exemplary embodiments.

The PV sandwich panel may be manufactured in various manners.

For example, in a preferred embodiment, the components are stacked in a rigid mold which determines the final shape of the sandwich panel. Typically, flat steel molds are used for this purpose. The mold might be preheated, typically to between 30°C and 70°C. An example of the process can be the following:
- An inner finishing layer (if present) is placed in the mold. Then this layer is coated with a polymeric bonding agent (e.g., PU glue, a thermosetting resin, etc).
- An inner skin forming the stabilization layer of the sandwich panel is placed in the mold and is coated with a polymeric bonding agent.
- An insulating core formed by a foam sheet is placed on top of the inner skin and is coated with a polymeric bonding agent.
- Optionally, an outer skin of the sandwich panel is placed in the mold and is coated with a polymeric bonding agent.
- The PV label with a front stabilization layer is placed on top of the outer skin while making sure that terminals of the PV module are in contact with exposed contacts in the core.
- The mold is brought into a hot press to allow for the curing of the polymeric bonding agent. Depending on the bonding agent employed the press might exert a pressure on the stack or might simply seal the mold to contain the expansion of the bonding agent. The pressure during this process will typically reach 2 to 6 bar. In addition, the press might be heated to control the curing temperature and the final mechanical and thermal properties of the bonding agent. Typical curing temperatures of thermosetting resins range from 50°C to 300°C, where high temperatures are used to obtain polymers with higher glass transition temperatures. Typically temperatures lower than 150°C will be used to preserve the properties of the core and the PV label encapsulation. Pressing times can range from 5 minutes to 2 hours depending on the bonding agent.

In some cases, for example when using thermosetting resins as a bonding agent, the sandwich panel shall be allowed to cure in room temperature conditions between 30 minutes to 5 hours to continue developing the curing process.

It is to be noted that the method may be reversed, meaning that it may start by placing the PV label first and the stabilization layer and/or the inner finishing layer last.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV sandwich panel
- 3: sheet-like photovoltaic label
- 5: foam sheet
- 7: stabilisation layer
- 9: front side stabilisation foil
- 11: front side polymeric lamination foil
- 13: rear side polymeric lamination foil
- 15: rear side stabilisation foil
- 17: solar cell arrangement
- 19: solar cell
- 21: front side
- 23: rear side
- 25: thermally insulated cargo box
- 27: vehicle
- 29: insulation panel

## Claims

1. Photovoltaic sandwich panel (1), particularly photovoltaic vehicle cladding sandwich panel, comprising:
a sheet-like photovoltaic label (3),
a foam sheet (5),
a stabilisation layer (7),
wherein the photovoltaic label (3) comprises a front side polymeric lamination foil (11), a rear side polymeric lamination foil (13) and a solar cell arrangement (17) interposed between the front and rear side lamination foils (11, 13),
wherein the stabilisation layer is (7) fixed to a rear side (23) of the foam sheet (5), and
wherein the photovoltaic label (3) is fixed with its rear side to a front side (21) of the foam sheet (5).

2. Photovoltaic sandwich panel (1) according to claim 1,
wherein the photovoltaic label (3) further comprises a front side stabilisation foil (9).

3. Photovoltaic sandwich panel (1) according to one of the preceding claims,
wherein the foam sheet (5) has a heat transmission coefficient of less than 1 W/m²K.

4. Photovoltaic sandwich panel (1) according to one of the preceding claims,
wherein the photovoltaic label (3) further comprises a rear side stabilisation foil (15).

5. Photovoltaic sandwich panel (1) according to one of the preceding claims,
wherein the foam sheet (5) has a thickness of between 0.5 cm and 15 cm.

6. Photovoltaic sandwich panel (1) according to one of the preceding claims,
wherein the foam sheet (5) has a thickness of between 2 cm and 6 cm.

7. Photovoltaic sandwich panel (1) according to one of the preceding claims,
wherein the photovoltaic label (3) has a thickness of between 0.1 cm and 1 cm.

8. Photovoltaic sandwich panel (1) according to one of the preceding claims,
wherein the solar cell arrangement (17) comprises multiple wafer-based semiconductor solar cells (19).

9. Photovoltaic sandwich panel (1) according to one of the preceding claims,
wherein the stabilisation layer (7) comprises a layer of at least one of fibre reinforced plastics, aluminium, steel and steel-alloy.

10. Photovoltaic sandwich panel (1) according to one of the preceding claims,
wherein at least one of the photovoltaic label (3) and the stabilisation layer (7) is fixed to the foam sheet (5) along its entire surface.

11. Photovoltaic sandwich panel (1) according to one of the preceding claims,
wherein the foam sheet (5) and the photovoltaic label (3) each comprise thicknesses which vary along lateral extensions of the respective component and wherein the foam sheet (5) is provided with depressed areas of reduced thickness such as to correspond to protruding areas of increased thickness of the photovoltaic label (3) in a complementary configuration.

12. Photovoltaic sandwich panel (1) according to one of the preceding claims,
wherein the foam sheet (3) comprises integrated electric connection structures which are configured for electrically interconnecting an electric contact provided at a surface of the photovoltaic label (5) to a connector contact which is provided at the photovoltaic sandwich such as to be externally accessible.

13. Thermally insulated cargo box (25) comprising a cargo volume enclosed by multiple insulation panels (29) including a roof panel, a bottom panel and several side panels, wherein at least one of the insulation panels (29) is made with a photovoltaic sandwich panel (1) according to one of the preceding claims.

14. Vehicle (27) comprising a thermally insulated cargo box (25) according to claim 13.

15. Method for manufacturing a photovoltaic sandwich panel, including:
- providing a reversible closable mold with a cavity having inner dimensions corresponding to dimensions of the photovoltaic sandwich panel;
- inserting a sheet-like photovoltaic label (3), a foam sheet (5) and a stabilisation layer (7) such as to form a layer stack within the cavity of the mold, wherein the photovoltaic label (3) comprises a front side polymeric lamination foil (11), a rear side polymeric lamination foil (13) and a solar cell arrangement (17) interposed between the front and rear side lamination foils (11, 13) and wherein a curable layer of adhesive material is interposed between each of the components in the layer stack;
- closing the mold and, optionally, heating at least portions of the mold and/or pressing opposing surfaces of the mold such as to cure the adhesive material in the curable layers to thereby fix the stabilisation layer to the rear side (23) of the foam sheet (5) and to fix the photovoltaic label (3) with its rear side to a front side (21) of the foam sheet (5).
